# EUROPEAN PATENT APPLICATION

(11) **EP 4 640 646 A1**
(43) Date of publication of application: **29.10.2025**
(21) Application number: 25171926.6
(22) Date of filing: 23.04.2025
(51) Int. Cl.: C03C 17/34, B32B 17/00

(54) **WINDOW AND ELECTRONIC DEVICE INCLUDING THE SAME**

(30) Priority: 24.04.2024 KR 20240054949
(71) Applicant: Samsung Display Co., Ltd., Gyeonggi-do (KR)
(72) Inventor: CHUNG, Yung Bin, Yongin-si (KR); KIM, Jingyu, Yongin-si (KR)
(74) Representative: Marks & Clerk LLP

(57) **Abstract**

A window includes a base layer, a functional layer disposed on the base layer, and a cover glass disposed on the functional layer. The functional layer of the window includes a first coating layer disposed on the base layer, including aluminium oxide (AlOₓ), and having a density of about 2.0 g/cm³ or greater, and a second coating layer disposed on the first coating layer.

## Description

### BACKGROUND

### (1) Field

The disclosure herein relates to a window, and more particularly, to an electronic device including the window.

### (2) Description of the Related Art

Various types of electronic device are being used for providing image information. Recently, electronic devices including a flexible display panel capable of being folded or bent are being developed. A flexible electronic device is deformable into various shapes, for example, foldable, rollable, bendable, etc., and thus has a characteristic of being portable regardless of a display screen size.

An electronic device typically includes a window for protecting a display panel, etc., and accordingly, the development of a window that maintains high display quality is desired.

### SUMMARY

Embodiments of the disclosure provide a window with high reliability.

Embodiments of the disclosure also provide an electronic device with high display quality.

An embodiment of the invention provides a window including: a base layer; a functional layer disposed on the base layer; and a cover glass disposed on the functional layer. In such an embodiment, the functional layer includes a first coating layer disposed on the base layer, including aluminium oxide (AlOₓ), and having a density of about 2.0 grams per cubic centimeter (g/cm³) or greater, and a second coating layer disposed on the first coating layer and including an inorganic material.

In an embodiment, the first coating layer may have a density of about 2.3 g/cm³ or greater.

In an embodiment, the first coating layer may not include a fluorine element.

In an embodiment, the first coating layer may further include a fluorine element, and when analyzed through X-ray photoelectron spectroscopy (XPS), the fluorine element included in the first coating layer may have a peak intensity of about 5 × 10² counts per second (c/s) or less.

In an embodiment, the functional layer may have a thickness in a range of about 295 nanometers (nm) to about 365 nm.

In an embodiment, a thickness of the first coating layer may be less than a thickness of the second coating layer.

In an embodiment, the first coating layer may have a thickness in a range of about 26 nm to about 40 nm.

In an embodiment, the second coating layer may include a low-refractive-index layer, and a high-refractive-index layer.

In an embodiment, the second coating layer may include: a first low-refractive-index layer disposed on the first coating layer, a first high-refractive-index layer disposed on the first low-refractive-index layer, a second low-refractive-index layer disposed on the first high-refractive-index layer, a second high-refractive-index layer disposed on the second low-refractive-index layer, and a third low-refractive-index layer disposed on the second high-refractive-index layer.

In an embodiment, the first low-refractive-index layer, the second low-refractive-index layer, and the third low-refractive-index layer may include a same material as each other.

In an embodiment, the first high-refractive-index layer, and the second high-refractive-index layer may include a same material as each other.

In an embodiment, the second coating layer may include at least one selected from SiO or TiOₓ.

In an embodiment, the second coating layer may include: a first sub-coating layer including the SiO, and a second sub-coating layer including the TiOₓ.

In an embodiment, the functional layer may further include a third coating layer disposed on the second coating layer and including an organic material.

In an embodiment, the third coating layer may include SiOC.

In an embodiment, the base layer may include a glass substrate or a polymer film.

In an embodiment of the invention, a window includes: a base layer; a first coating layer disposed on the base layer, including aluminium oxide (AlOₓ), and having a density of about 2.3 g/cm³ or greater; a first low-refractive-index layer disposed on the first coating layer; a first high-refractive-index layer disposed on the first low-refractive-index layer; a second low-refractive-index layer disposed on the first high-refractive-index layer; a second high-refractive-index layer disposed on the second low-refractive-index layer; and a third low-refractive-index layer disposed on the second high-refractive-index layer.

In an embodiment, each of the first low-refractive-index layer, the second low-refractive-index layer, and the third low-refractive-index layer may include SiO.

In an embodiment, each of the first high-refractive-index layer and the second high-refractive-index layer may include TiOₓ.

In an embodiment, the first coating layer may further include a fluorine element, and when analyzed through X-ray photoelectron spectroscopy (XPS), the fluorine element included in the first coating layer may have a peak intensity of about 5 ×10² c/s or less.

In an embodiment of the invention, an electronic device includes: a first display device which includes a folding region foldable with respect to a folding axis extending in one direction, and a first non-folding region and a second non-folding region spaced apart with the folding region therebetween, where the first display device displays a first image in the folding region, the first non-folding region, and the second non-folding region; and a second display device disposed to overlap the first non-folding region, where the second display device displays a second image in a direction opposite to the first image. In such an embodiment, the second display device includes a display panel, and a window disposed on the display panel, the window includes a base layer, and a functional layer disposed on the base layer, and the functional layer includes a first coating layer disposed on the base layer, including aluminium oxide (AlOₓ), and having a density of about 2.0 g/cm³ or greater, and a second coating layer disposed on the first coating layer and including an inorganic material.

In an embodiment, the second display device may not overlap the folding region and the second non-folding region.

In an embodiment, the first coating layer may have a density of about 2.3 g/cm³ or greater.

At least some of the above and other features of the invention are set out in the claims.

### BRIEF DESCRIPTION OF THE DRAWINGS

The above and other features of embodiments of the invention will become more apparent by describing in further detail embodiments thereof with reference to the accompanying drawings, in which:
FIG. 1A is a perspective view of an electronic device according to an embodiment;
FIG. 1B is a perspective view of an electronic device according to an embodiment;
FIG. 1C is a perspective view of an electronic device according to an embodiment;
FIG. 2 is a perspective view of an electronic device according to an embodiment;
FIG. 3 is a schematic cross-sectional view of a display device according to an embodiment;
FIG. 4 is a cross-sectional view of a display panel according to an embodiment;
FIGS. 5A and 5B are cross-sectional views of a window according to an embodiment;
FIGS. 5C to 5E are enlarged cross-sectional views of a part of a window according to an embodiment;
FIG. 6 is a graph showing reliability evaluation results of windows of experimental groups; and
FIG. 7 is a graph showing results of analyzing the concentration of fluoride included in a window.

### DETAILED DESCRIPTION

The invention now will be described more fully hereinafter with reference to the accompanying drawings, in which various embodiments are shown. This invention may, however, be embodied in many different forms, and should not be construed as limited to the embodiments set forth herein. Rather, these embodiments are provided so that this disclosure will be thorough and complete, and will fully convey the scope of the invention to those skilled in the art.

It will be understood that when an element is referred to as being "on" another element, it can be directly on the other element or intervening elements may be present therebetween. In contrast, when an element is referred to as being "directly on" another element, there are no intervening elements present.

In this specification, it will be understood that when an element (or region, layer, portion, or the like) is referred to as being "connected to" or "coupled to" another element, it may be directly connected/coupled to another element, or intervening elements may be disposed therebetween.

Like reference numerals or symbols refer to like elements throughout. Also, in the drawings, the thickness, the ratio, and the dimension of the elements are exaggerated for effective description of the technical contents.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The term "lower," can therefore, encompass both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. Thus, reference to "an" element in a claim followed by reference to "the" element is inclusive of one element and a plurality of the elements. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10% or 5% of the stated value.

Unless otherwise defined, all terms (including technical and scientific terms) used herein have the same meaning as commonly understood by one of ordinary skill in the art to which this disclosure belongs. Also, terms, such as those defined in commonly used dictionaries, should be interpreted as having a meaning that is consistent with their meaning in the context of the relevant art and should not be interpreted in an idealized or overly formal sense unless expressly so defined herein.

Embodiments are described herein with reference to cross section illustrations that are schematic illustrations of embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

Hereinafter, a window of an embodiment and an electronic device according to embodiments of the disclosure will be described with reference to the accompanying drawings.

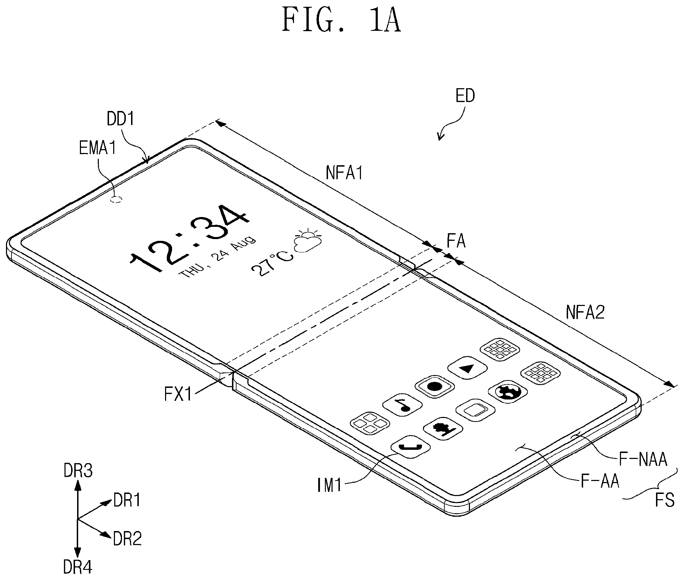

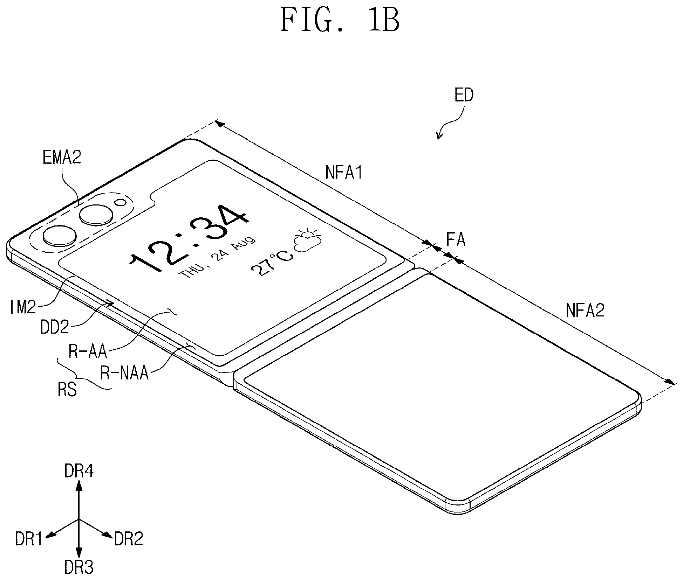

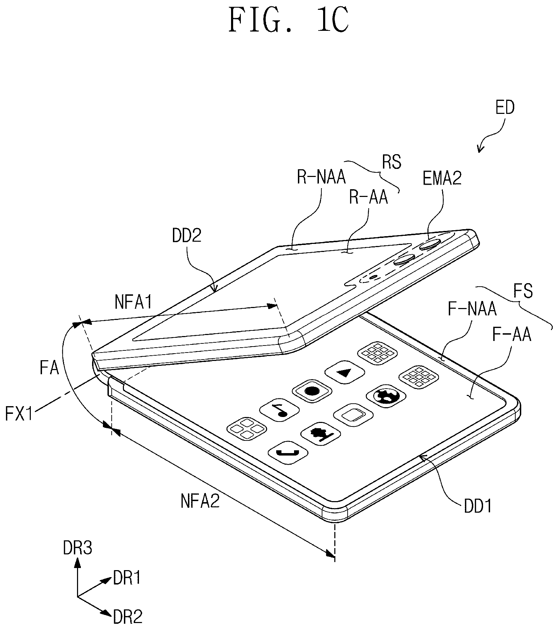

FIGS. 1A to 1C are perspective views of an electronic device ED according to an embodiment. FIG. 1A is a perspective view illustrating an unfolded state of the electronic device ED according to an embodiment. FIG. 1B is a perspective view of a rear surface of the electronic device ED illustrated in FIG. 1A. FIG. 1C is a perspective view for illustrating that the electronic device ED illustrated in FIG. 1A is being in-folded.

Referring to FIGS. 1A to 1C, the electronic device ED of an embodiment may be activated in response to an electrical signal. In an embodiment, for example, the electronic device ED may be a mobile phone, a tablet computer, a car navigation system, a game console, or a wearable device, but an embodiment of the invention is not limited thereto. In an embodiment, as shown in FIG. 1A, etc., the electronic device ED may be a mobile phone, for example.

The electronic device ED according to an embodiment may detect an external input applied from the outside. The external input may include various types of inputs applied from the outside of the electronic device ED. In an embodiment, for example, the external input may include not only a touch by a part of a user's body such as user's hands but also an external input (for example, hovering) applied while approaching or being adjacent within a predetermined distance to the electronic device ED. Additionally, the external input may have various forms such as force, pressure, temperature, and light.

In an embodiment, the electronic device ED may include a first display device DD1 and a second display device DD2. The first display device DD1 and the second display device DD2 may be individual devices separated from each other. The area of the second display device DD2 may be smaller than the area of the first display device DD1. The first display device DD1 may be referred to as a main display device, and the second display device DD2 may be referred to as an auxiliary display device or an external display device.

In an embodiment, the electronic device ED may include a first display surface FS and a second display surface RS. The first display device DD1 may include the first display surface FS defined by a first direction axis DR1 and a second direction axis DR2 crossing the first direction axis DR1. The first display device DD1 may provide a first image IM1 to users through the first display surface FS. The first display device DD1 may display, in a third direction axis DR3, the first image IM1 on the first display surface FS parallel to each of the first direction axis DR1 and the second direction axis DR2.

The second display device DD2 may include the second display surface RS. The second display device DD2 may provide a second image IM2 to users through the second display surface RS. The second display surface RS may be defined as a surface opposed to at least a portion of the first display surface FS. That is, the second display surface RS may be defined as a portion of a rear surface of the electronic device ED. Accordingly, in an unfolded state of the electronic device ED of an embodiment, the first image IM1 displayed on the first display surface FS, and the second image IM2 displayed on the second display surface RS may be displayed in opposite directions.

In the disclosure, the first direction axis DR1 and the second direction axis DR2 may be orthogonal to each other, and the third direction axis DR3 may be a normal direction of a plane defined by the first direction axis DR1 and the second direction axis DR2. A thickness direction of the electronic device ED may be a direction parallel to the third direction axis DR3. Accordingly, a front surface (or upper surface) and a rear surface (or lower surface) of members constituting the electronic device ED may be defined based on the third direction axis DR3. The front surface and the rear surface may be opposed to each other in the third direction axis DR3, and a normal direction of each of the front surface and the rear surface may be parallel to the third direction axis DR3. The front surface is referred to as a surface close to the first display surface FS, and the rear surface is referred to as a surface spaced apart from the first display surface FS. Additionally, the rear surface is referred to as a surface close to the second display surface RS. An upper side is referred to as a direction of getting closer to the first display surface FS, and a lower side is referred to as a direction of getting farther away from the first display surface FS.

In the disclosure, a cross section of components is referred to as a surface parallel to the thickness direction DR3, and a plane is referred to as a surface perpendicular to the thickness direction DR3. In addition, a plan view may be a view viewed in the third direction DR3. The plane is referred to as a surface defined by the first direction axis DR1 and the second direction axis DR2. A direction of a fourth direction axis DR4 is referred to as a direction opposite to a direction of the third direction axis DR3.

The directions indicated by the first to fourth direction axes DR1, DR2, DR3, and DR4 described herein have a relative concept, and may thus be changed to other directions. In addition, the directions indicated by the first to fourth direction axes DR1, DR2, DR3, and DR4 may be referred to as first to fourth directions, and may be denoted as the same reference numerals or symbols.

The first display surface FS may include a first active region F-AA and a first peripheral region F-NAA. A first electronic module region EMA1 may be included in the first active region F-AA. The first active region F-AA may be activated in response to an electrical signal. The electronic device ED according to an embodiment may display the first image IM1 through the first active region F-AA. Also, various types of external inputs may be detected in the first active region F-AA.

The first peripheral region F-NAA may be a region in which the first image IM1 is not displayed. The first peripheral region F-NAA may be adjacent to the first active region F-AA. The first peripheral region F-NAA may have a predetermined color. The first peripheral region F-NAA may surround the first active region F-AA. Accordingly, a shape of the first active region F-AA may be substantially defined by the first peripheral region F-NAA. However, this is exemplarily illustrated. The first peripheral region F-NAA may be disposed to be adjacent to only one side of the first active region F-AA, or may be omitted. The electronic device ED according to an embodiment may include the first active region F-AA having various shapes, and is not limited to any one embodiment.

The second display surface RS may include a second active region R-AA which displays the second image IM2. The second active region R-AA may be activated in response to an electrical signal. The electronic device ED may display the second image IM2 through the second active region R-AA. Additionally, the electronic device ED may detect various types of external inputs in the second active region R-AA.

The second display surface RS may include a second peripheral region R-NAA. The second peripheral region R-NAA may be adjacent to the second active region R-AA. The second peripheral region R-NAA may have a predetermined color. The second peripheral region R-NAA may surround the second active region R-AA. Also, the second display surface RS may include a second electronic module region EMA2 in which an electronic module including various components is disposed. The second electronic module region EMA2 may be included in the second peripheral region R-NAA. The second electronic module region EMA2 may be disposed inside the second active region R-AA, and is not limited to any one embodiment.

Various electronic modules may be disposed in the first and second electronic module regions EMA1 and EMA2. In an embodiment, for example, the electronic module may include at least one selected from a camera, a speaker, a light detection sensor, and a heat detection sensor. The first and second electronic module regions EMA1 and EMA2 may respectively detect external subjects received through the first and second display surfaces FS and RS or provide a sound signal such as voice to the outside through the first and second display surfaces FS and RS. The electronic module may include a plurality of components, and is not limited to any one embodiment.

In an embodiment, the electronic device ED may include a folding region FA and non-folding regions NFA1 and NFA2. In an embodiment, the non-folding regions NFA1 and NFA2 may be disposed adjacent to the folding region FA with the folding region FA therebetween. The electronic device ED may include a first non-folding region NFA1 and a second non-folding region NFA2 which are disposed to be spaced apart from each other in the second direction DR2 with the folding region FA therebetween. In an embodiment, for example, the first non-folding region NFA1 may be disposed on one side of the folding region FA along the second direction DR2, and the second non-folding region NFA2 may be disposed on the other side of the folding region FA along the second direction DR2.

The first display device DD1 may include the folding region FA and the non-folding regions NFA1 and NFA2. The first display surface FS of the first display device DD1 may overlap the folding region FA and the non-folding regions NFA1 and NFA2. The second display device DD2 may overlap one region among a plurality of non-folding regions NFA1 and NFA2. In an embodiment, for example, the second display device DD2 may overlap the first non-folding region NFA1. The second display device DD2 may not overlap the folding region FA and the second non-folding region NFA2. The second display surface RS of the second display device DD2 may overlap the first non-folding region NFA1.

A display direction of the first image IM1 displayed in a portion of the first display device DD1, for example, in the first non-folding region NFA1, may be opposite to a display direction of the second image IM2 displayed in the second display device DD2. In an embodiment, for example, in a state in which the electronic device ED is unfolded, the first image IM1 may be displayed in the third direction DR3, and the second image IM2 may be displayed in the fourth direction DR4 opposite to the third direction DR3.

FIGS. 1A to 1C illustrate an embodiment where the electronic device ED includes a single folding region FA, but an embodiment of the invention is not limited thereto. In another embodiment, a plurality of folding regions may be defined in the electronic device ED. For example, the electronic device according to an embodiment may include two or more folding regions, and may also include three or more non-folding regions disposed with the folding regions therebetween.

Referring to FIG. 1C, the electronic device ED according to an embodiment may be folded with respect to a first folding axis FX1. The first folding axis FX1 may be an imaginary axis extending in the first direction DR1, and be parallel to a short-side direction of the electronic device ED. The first folding axis FX1 is not limited thereto, and may be parallel to a long-side direction of the electronic device ED. The first folding axis FX1 may extend along the first direction DR1 on the first display surface FS.

The electronic device ED may be folded with respect to the first folding axis FX1 and be changed into an in-folded state in which in the first display surface FS, one region overlapping the first non-folding region NFA1 and the other region overlapping the second non-folding region NFA2 face each other. The electronic device ED may be in-folded such that the first display surface FS is not exposed to the outside. In an in-folded state of the electronic device ED, the folding region FA may have a predetermined curvature and a radius of curvature. The second display surface RS of the electronic device ED may be visible to a user in an in-folded state, and the second image IM2 may be displayed in the third direction DR3.

In some embodiments, the electronic device ED may be out-folded such that the first display device DD1 is exposed to the outside. The electronic device ED of an embodiment may be in-folded or out-folded from an unfolded state, and is not limited to any one embodiment.

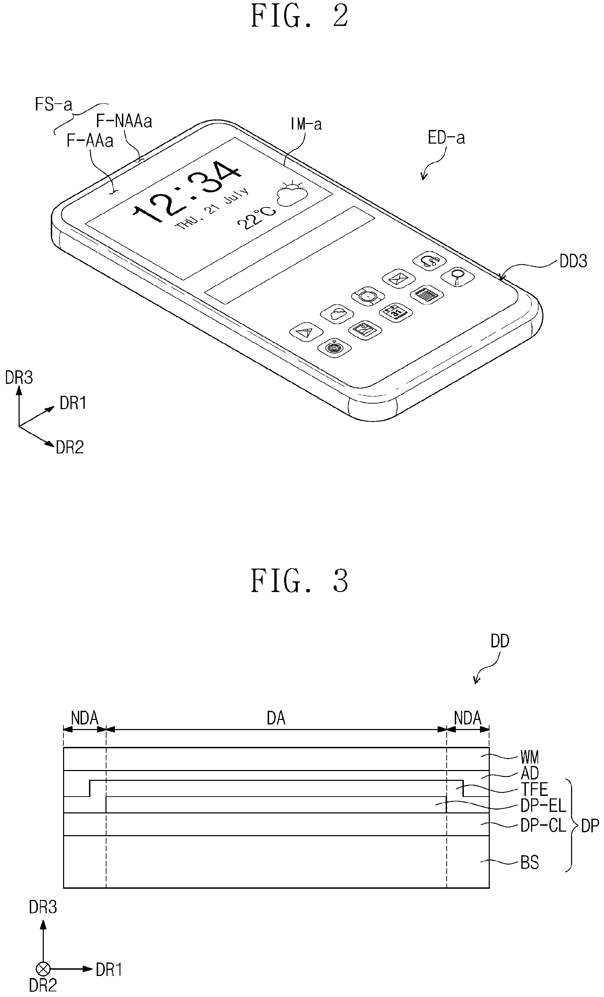

FIG. 2 is a perspective view of an electronic device ED-a according to an embodiment. The electronic device ED-a illustrated in FIG. 2 may be a flat electronic device ED-a which does not include a folding region.

Referring to FIG. 2, the electronic device ED-a of an embodiment may include a third display device DD3. The third display device DD3 may include a display surface FS-a parallel to each of the first direction DR1 and the second direction DR2. The third display device DD3 may provide an image IM-a to users through a display surface FS-a. FIG. 2 illustrates an embodiment where the display surface FS-a is a flat surface. In another embodiment, the display surface FS-a may include a curved surface bent from at least one side of a flat surface. In the flat electronic device ED-a, the image IM-a may be displayed in the third direction DR3.

The display surface FS-a may include an active region F-AAa and a peripheral region F-NAAa. The description of the second active region R-AA and the second peripheral region R-NAA described with reference to FIG. 1A, etc., may be similarly applied to the active region F-AAa and the peripheral region F-NAAa. The display surface FS-a may further include an electronic module region in which an electronic module including various components is disposed, and is not limited to any one embodiment.

FIG. 3 is a schematic cross-sectional view of a display device DD according to an embodiment. The display device DD of FIG. 3 may be the second display device DD2 of FIG. 1B. The display device DD of FIG. 3 is not limited thereto, and may be the third display device DD3 of FIG. 2. In a case in which the display device DD of FIG. 3 corresponds to the second display device DD2, the display device DD of FIG. 3 may represent the second display device DD2 of the electronic device ED of FIG. 1B in an in-folded state.

Referring to FIG. 3, the display device DD of an embodiment may include a display panel DP and a window WM. The display panel DP and the window WM may be bonded to each other via an adhesive layer AD. The display device DD may display the images IM2 and IM-a (see FIGS. 1B and 2) through the display region DA. A non-display region NDA may be adjacent to the display region DA. The display region DA may correspond to the second active region R-AA of the second display device DD2 illustrated in FIG. 1B, or correspond to the active region F-AAa of the third display device DD3 illustrated in FIG. 2. The non-display region NDA may correspond to the second peripheral region R-NAA of the second display device DD2 illustrated in FIG. 1B, or correspond to the peripheral region F-NAAa of the third display device DD3 illustrated in FIG. 2.

The display panel DP may be a component that substantially generates the images IM2 and IM-a (see FIGS. 1B and 2). The display panel DP may be a light-emitting display panel. In an embodiment, for example, the display panel DP may be an organic light-emitting display panel, an inorganic light-emitting display panel, a micro light-emitting diode (LED) display panel, or a nano LED display panel. The display panel DP may also be referred to as a display layer. The display panel DP may include a base substrate BS, a circuit layer DP-CL, a display element layer DP-EL, and an encapsulation layer TFE.

The base substrate BS may be a member that provides a base surface on which the circuit layer DP-CL is disposed. The base substrate BS may be a rigid substrate or a flexible substrate which is bendable, foldable, rollable, etc. The base substrate BS may be a glass substrate, a metal substrate, a polymer substrate, etc. However, an embodiment of the invention is not limited thereto, and the base substrate BS may include an inorganic layer, an organic layer, or a composite material layer.

The base substrate BS may have a multi-layered structure. In an embodiment, for example, the base substrate BS may include a first synthetic resin layer, a multi- or single-layered inorganic layer, or a second synthetic resin layer disposed on the multi- or single-layered inorganic layer. The first and second synthetic resin layers may each include a polyimide-based resin, and are not particularly limited.

The circuit layer DP-CL may be disposed on the base substrate BS. The circuit layer DP-CL may include an insulating layer, semiconductor patterns, conductive patterns, a signal line, etc.

The display element layer DP-EL may be disposed on the circuit layer DP-CL. The display element layer DP-EL may include a light-emitting element. In an embodiment, for example, the light-emitting element may include an organic light-emitting material, an inorganic light-emitting material, an organic-inorganic light-emitting material, quantum dots, quantum rods, a micro LED, or a nano LED.

The encapsulation layer TFE may be disposed on the display element layer DP-EL. The encapsulation layer TFE may overlap the display region DA and the non-display region NDA and cover the display element layer DP-EL. The encapsulation layer TFE may protect a light-emitting element of the display element layer DP-EL against moisture, oxygen, and foreign substances such as dust particles. The encapsulation layer TFE may include at least one inorganic layer. The encapsulation layer TFE may further include at least one organic layer. The encapsulation layer TFE may include a stacked structure of an inorganic layer/an organic layer/an inorganic layer.

The display device DD of an embodiment may further include, between the display panel DP and the window WM, a sensor layer which detects an external input, a light control layer such as an anti-reflection layer, and the like. In an embodiment, for example, the display device DD may further include the sensor layer and the light control layer which are sequentially disposed on the display panel DP, and the light control layer may be bonded to the window WM via the adhesive layer AD. However, an embodiment of the invention is not limited thereto, and positions of the sensor layer and the light control layer may be switched with each other.

The sensor layer may be disposed on the display panel DP. The sensor layer may detect an external input applied from the outside. The external input may be a user's input. The user's input may include various types of external inputs such as a part of a user's body, light, heat, pen, or pressure.

In an embodiment, the sensor layer may be formed on the display panel DP through a continuous process. In such an embodiment, the sensor layer may be directly disposed on the display panel DP. Here, the wording, "being directly disposed" may mean that another component is not disposed between the sensor layer and the display panel DP. That is, an additional adhesive member may not be disposed between the sensor layer and the display panel DP.

The light control layer may be disposed on the sensor layer. In an embodiment, for example, the light control layer may be directly disposed on the sensor layer. The light control layer may reduce reflectance for external light incident from the outside of the display device DD. The light control layer may be formed on the sensor layer through a continuous process.

The window WM may define a front surface of the display device DD. The window WM may be disposed above the display panel DP, and cover the entire upper surface of the display panel DP.

The window WM may have a shape corresponding to that of the display panel DP. The window WM may be a substrate or a film, including or containing glass or a polymer material. In an embodiment, the window WM may further include a functional layer disposed on a substrate or a film which serves as a base. The window WM will be described later in greater detail.

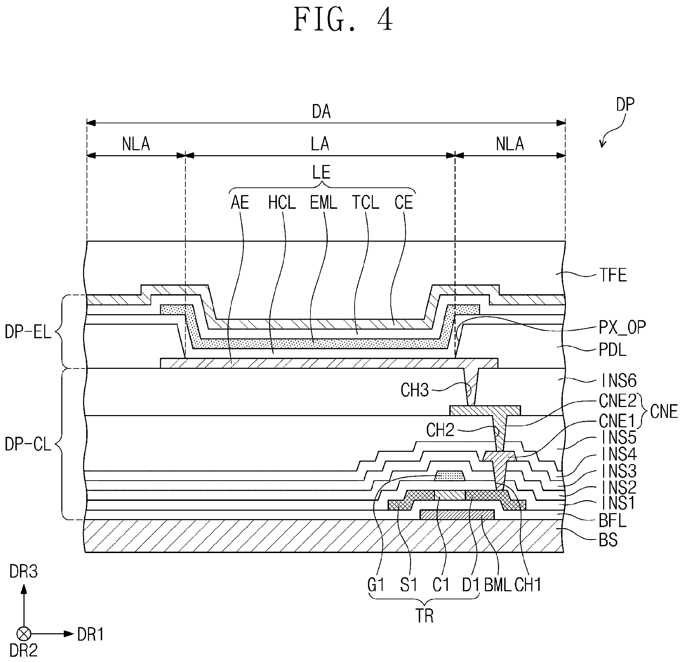

FIG. 4 is a cross-sectional view of a display panel DP according to an embodiment. FIG. 4 may be a cross-sectional view illustrating, in greater detail, a configuration of the display panel DP illustrated in FIG. 3. The display panel DP may include a transistor TR and a light-emitting element LE. The transistor TR and the light-emitting element LE may be disposed on a base substrate BS. For convenience of illustration and description, FIG. 4 illustrates only one transistor TR and only one light-emitting element LE, but the display panel DP may include at least one capacitor and a plurality of transistors for driving the light-emitting element LE.

A circuit layer DP-CL may be disposed on the base substrate BS. The circuit layer DP-CL may include a shielding electrode BML, a transistor TR, a connection electrode CNE, and a plurality of insulating layers BFL and INS1 to INS6. The plurality of insulating layers BFL and INS1 to INS6 may include a buffer layer BFL and first to sixth insulating layers INS1 to INS6. However, the stacked structure of the circuit layer DP-CL illustrated in FIG. 4 is merely an example, and the stacked structure of the circuit layer DP-CL may be variously changed or modified according to a configuration of a pixel and a process for the circuit layer DP-CL.

A shielding electrode BML may be disposed on the base substrate BS. The shielding electrode BML may overlap the transistor TR. The shielding electrode BML may block light incident onto the transistor TR from below the display panel DP to protect the transistor TR. The shielding electrode BML may include a conductive material. When a voltage is applied to the shielding electrode BML, a threshold voltage of the transistor TR disposed on the shielding electrode BML may be maintained. However, an embodiment of the invention is not limited thereto, and the shielding electrode BML may be a floating electrode. In another embodiment, the shielding electrode BML may be omitted.

The buffer layer BFL may be disposed on the base substrate BS and cover the shielding electrode BML. The buffer layer BFL may include an inorganic layer. The buffer layer BFL may improve a bonding force between the base substrate BS and a semiconductor pattern or a conductive pattern, which is disposed on the buffer layer BFL.

The transistor TR may include a source S1, a channel C1, a drain D1, and a gate G1. The source S1, the channel C1, and the drain D1 of the transistor TR may be formed from or defined by a semiconductor pattern. The semiconductor pattern of the transistor TR may include polysilicon, amorphous silicon, or a metal oxide. However, any material having semiconductor properties may be used without any limitation and is not limited to any one embodiment.

The semiconductor pattern may include a plurality of regions divided according to a conductivity level. In the semiconductor pattern, a region, which is doped with a dopant or in which a metal oxide is reduced, may have a high conductivity, and may serve substantially as a source electrode and a drain electrode of the transistor TR. A highly conductive region of the semiconductor pattern may correspond to the source S1 and the drain D1 of the transistor TR. In the semiconductor pattern, a region, which is undoped or lightly doped or which has a low conductivity due to a non-reduced metal oxide, may correspond to the channel C1 (or active) of the transistor TR.

The first insulating layer INS1 may cover the semiconductor pattern of the transistor TR and be disposed on the buffer layer BFL. The gate G1 of the transistor TR may be disposed on the first insulating layer INS1. The gate G1 may overlap the channel C1 of the transistor TR. The gate G1 may function as a mask during the process of doping the semiconductor pattern of the transistor TR.

The second insulating layer INS2 may cover the gate G1 and be disposed on the first insulating layer INS1. The third insulating layer INS3 may be disposed on the second insulating layer INS2.

The connection electrode CNE may include a first connection electrode CNE1 and a second connection electrode CNE2 which electrically connect the transistor TR and the light-emitting element LE. However, a configuration of the connection electrode CNE which electrically connects the transistor TR to the light-emitting element LE is not limited to the configuration described above. Either of the first connection electrode CNE1 or the second connection electrode CNE2 may be omitted, or an additional connection electrode may be further included.

The first connection electrode CNE1 may be disposed on the third insulating layer INS3. The first connection electrode CNE1 may be connected to the drain D1 via a first contact hole CH1 defined or formed through the first to third insulating layers INS1 to INS3. The fourth insulating layer INS4 may cover the first connection electrode CNE1 and be disposed on the third insulating layer INS3. The fifth insulating layer INS5 may be disposed on the fourth insulating layer INS4.

The second connection electrode CNE2 may be disposed on the fifth insulating layer INS5. The second connection electrode CNE2 may be connected to the first connection electrode CNE1 via a second contact hole CH2 defined or formed through the fourth and fifth insulating layers INS4 and INS5. The sixth insulating layer INS6 may cover the second connection electrode CNE2 and be disposed on the fifth insulating layer INS5.

The first to sixth insulating layers INS1 to INS6 may each include an inorganic layer or an organic layer. In an embodiment, for example, the inorganic layer may include at least one selected from aluminium oxide, titanium oxide, silicon oxide, silicon oxynitride, zirconium oxide, and hafnium oxide. The organic layer may include at least one selected from an acryl-based resin, a methacryl-based resin, a polyisoprene-based resin, a vinyl-based resin, an epoxy-based resin, a urethane-based resin, a cellulose-based resin, a siloxane-based resin, a polyamide-based resin, and a perylene-based resin.

A display element layer DP-EL may include a pixel-defining film PDL and a light-emitting element LE. The light-emitting element LE may include a first electrode AE, a hole control layer HCL, a light-emitting layer EML, an electron control layer TCL, and a second electrode CE.

The first electrode AE may be disposed on the sixth insulating layer INS6. The first electrode AE may be connected to the second connection electrode CNE2 via a third contact hole CH3 defined or formed through the sixth insulating layer INS6. The first electrode AE may be electrically connected to the drain D1 of the transistor TR via the first and second connection electrodes CNE1 and CNE2.

The first electrode AE may include or be formed of a metal material, metal alloy, or conductive compound. The first electrode AE may be an anode or a cathode. However, an embodiment of the invention is not limited thereto. Also, the first electrode AE may be a pixel electrode. The first electrode AE may be a transmissive electrode, a transflective electrode, or a reflective electrode. The first electrode AE may include at least one selected from Ag, Mg, Cu, Al, Pt, Pd, Au, Ni, Nd, Ir, Cr, Li, Ca, LiF, Mo, Ti, W, In, Sn, and Zn; a compound of two or more materials selected therefrom; a mixture of two or more materials selected therefrom; or an oxide thereof.

In an embodiment where the first electrode AE is the transmissive electrode, the first electrode AE may include a transparent metal oxide, for example, indium tin oxide (ITO), indium zinc oxide (IZO), zinc oxide (ZnO), indium tin zinc oxide (ITZO), etc. When the first electrode AE is the transflective electrode or the reflective electrode, the first electrode AE may include Ag, Mg, Cu, Al, Pt, Pd, Au, Ni, Nd, Ir, Cr, Li, Ca, LiF/Ca (stacked structure of LiF and Ca), LiF/Al (stacked structure of LiF and Al), Mo, Ti, W, or a compound or mixture thereof (for example, a mixture of Ag and Mg). Alternatively, the first electrode AE may have a multi-layered structure including a reflective film or a transflective film, which include or is formed of the above-described materials, and a transparent conductive film including or formed of indium tin oxide (ITO), indium zinc oxide (IZO), zinc oxide (ZnO), indium tin zinc oxide (ITZO), etc. In an embodiment, for example, the first electrode AE may have a three-layered structure of ITO/Ag/ITO, but is not limited thereto. In addition, an embodiment of the invention is not limited thereto, and the first electrode AE may include the above-described metal materials, a combination of two or more metal materials selected from among the above-described metal materials, oxides of the above-described metal materials, etc.

The pixel-defining film PDL may be disposed on the sixth insulating layer INS6. A light-emitting opening PX_OP, which exposes a portion of the first electrode AE, may be defined in the pixel-defining film PDL. A portion of the first electrode AE, which is exposed by the light-emitting opening PX_OP, may be defined as a light-emitting region LA.

A region, in which the pixel-defining film PDL is disposed, may correspond to a light-blocking region NLA. The light-blocking region NLA may surround the light-emitting region LA in the display region DA. The display region DA of FIG. 4 may correspond to the second active region R-AA (see FIG. 1B) of the second display device DD2 (see FIG. 1B), or to the active region F-AAa (see FIG. 2) of the third display device DD3 (see FIG. 2).

The hole control layer HCL may be disposed on the first electrode AE and the pixel-defining film PDL. The hole control layer HCL may be provided as a common layer overlapping the light-emitting region LA and the light-blocking region NLA. The hole control layer HCL may include at least one among a hole transport layer, a hole injection layer, and an electron blocking layer. The hole control layer HCL may include a typical hole injection material and/or a typical hole transport material.

The light-emitting layer EML may be disposed on the hole control layer HCL. The light-emitting layer EML may be disposed in a region corresponding to the light-emitting opening PX_OP. Alternatively, the light-emitting layer EML may be provided as a common layer. The light-emitting layer EML may include an organic light-emitting material and/or an inorganic light-emitting material. The light-emitting layer EML may emit light having one color of red, green, or blue.

The electron control layer TCL may be disposed on the light-emitting layer EML. The electron control layer TCL may be provided as a common layer overlapping the light-emitting region LA and the light-blocking region NLA. The electron control layer TCL may include at least one selected from an electron transport layer, an electron injection layer, and a hole blocking layer. The electron control layer TCL may include a typical electron injection material and/or a typical electron transport material.

The second electrode CE may be disposed on the electron control layer TCL. The second electrode CE may be provided as a common layer overlapping the light-emitting region LA and the light-blocking region NLA. The second electrode CE may be disposed, in common, in the pixels and apply voltages to the pixels.

The second electrode CE may be a common electrode. The second electrode CE may be a cathode or an anode, but an embodiment of the invention is not limited thereto. In an embodiment, for example, where the first electrode AE is an anode, the second electrode CE may be a cathode. In an embodiment, for example, where the first electrode AE is a cathode, the second electrode CE may be an anode.

The second electrode CE may be a transmissive electrode, a transflective electrode, or a reflective electrode. In an embodiment where the second electrode CE is the transmissive electrode, the second electrode CE may include a transparent metal oxide, for example, indium tin oxide (ITO), indium zinc oxide (IZO), zinc oxide (ZnO), indium tin zinc oxide (ITZO), etc.

When the second electrode CE is the transflective electrode or the reflective electrode, the second electrode CE may include Ag, Mg, Cu, Al, Pt, Pd, Au, Ni, Nd, Ir, Cr, Li, Ca, LiF/Ca, LiF/Al, Mo, Ti, Yb, W, or a compound or a mixture thereof (for example, AgMg, AgYb, or MgYb). Alternatively, the second electrode CE may have a multi-layered structure including a reflective film or a transflective film, which includes or is formed of the above-described materials, and a transparent conductive film including or formed of indium tin oxide (ITO), indium zinc oxide (IZO), zinc oxide (ZnO), indium tin zinc oxide (ITZO), etc. In an embodiment, for example, the second electrode CE may include the above-described metal materials, a combination of two or more metal materials selected from the above-described metal materials, oxides of the above-described metal materials, etc.

An encapsulation layer TFE may be disposed on the second electrode CE and cover the light-emitting element LE. The encapsulation layer TFE may include a plurality of thin films. In an embodiment, for example, the encapsulation layer TFE may include inorganic films, disposed on the second electrode CE, and an organic film disposed between the inorganic films. The inorganic film may protect the light-emitting element LE against moisture/oxygen, and the organic film may protect the light-emitting element LE against foreign substances such as dust particles.

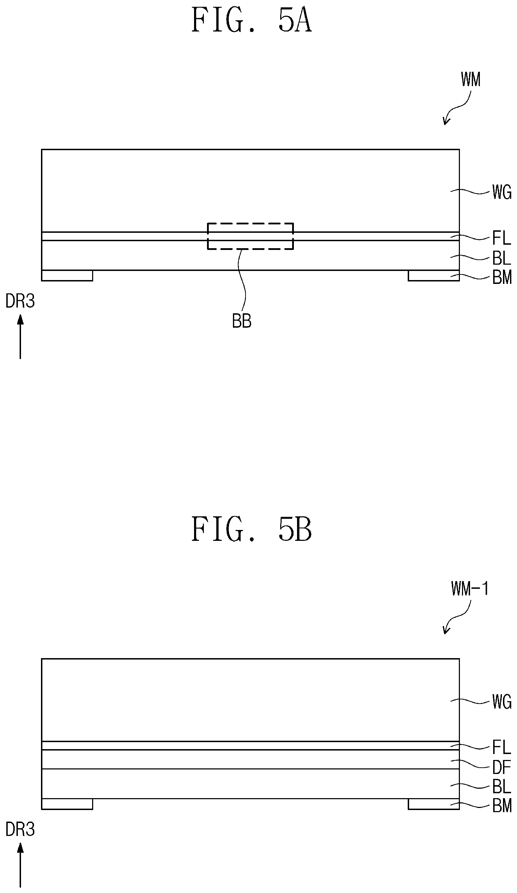

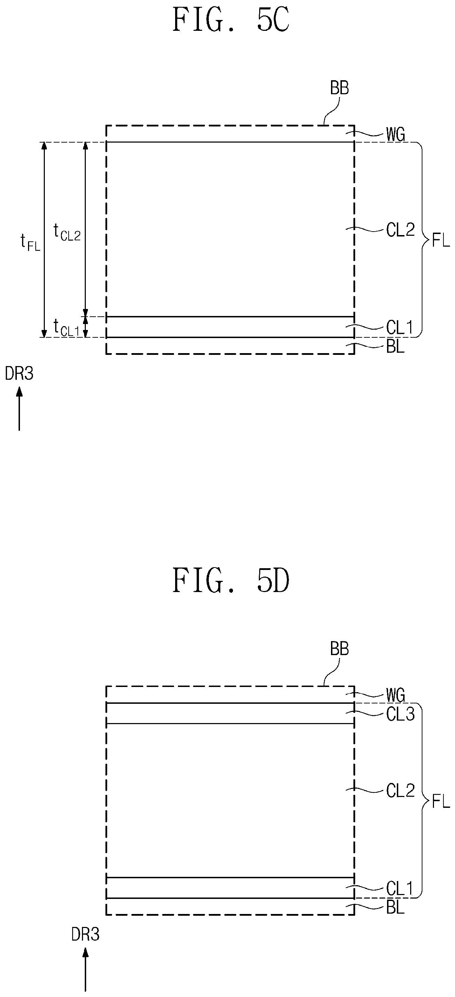

FIGS. 5A and 5B are respectively cross-sectional views of the windows WM and WM-1 according to an embodiment. FIGS. 5C to 5E are respectively enlarged cross-sectional views of a region BB of a window WM according to an embodiment.

Referring to FIG. 5A, the window WM of an embodiment may include a base layer BL, a functional layer FL, and a cover glass WG. The functional layer FL may include a plurality of layers different from each other. Also, the window WM may include a printed layer BM.

The window WM of an embodiment may include the base layer BL, the functional layer FL, the cover glass WG, and the printed layer BM. In the window WM of an embodiment, the base layer BL, the functional layer FL, and the cover glass WG may be sequentially stacked in the thickness direction DR3. The printed layer BM may overlap the non-display region NDA (FIG. 3), not overlap the display region DA (FIG. 3), and be disposed under the base layer BL. The printed layer BM may be an ink printing layer. In an embodiment, the printed layer BM may be a layer including a pigment or a dye.

The base layer BL may include a transparent material. In an embodiment, the base layer BL may include glass, tempered glass, or a polymer film. In an embodiment, the base layer BL may include a polyimide (PI) film or a polyethylene terephthalate (PET) film. In an embodiment, for example, the base layer BL may be a polyethylene terephthalate (PET) film. The base layer BL may be an organic substrate that has been subjected to chemical reinforcement. The base layer BL may have a multi-layered structure or a single-layered structure. In an embodiment, for example, the base layer BL may have a structure in which a plurality of polymer films are bonded to each other with an adhesive member, or a structure in which a glass substrate and a polymer film are bonded to each other with an adhesive. The base layer BL may include or be formed of a flexible material. The base layer BL may have a thickness in a range of about 20 micrometers (µm) to about 100 µm. In an embodiment, for example, the base layer BL may have a thickness of about 50 µm, but an embodiment of the invention is not limited thereto.

The functional layer FL may be disposed on the base layer BL. In an embodiment, for example, the functional layer FL may be disposed on an upper surface of the base layer BL. The functional layer FL may be disposed on a lower surface of the cover glass WG which is disposed on the uppermost part layer of the window WM. The functional layer FL may be disposed directly on a lower surface of the cover glass WG to improve color and properties of the cover glass WG. The functional layer FL may have a multi-layered structure in which layers are stacked in the thickness direction DR3. The functional layer FL may include a plurality of coating layers including an inorganic material.

The cover glass WG may be disposed on the functional layer FL. The cover glass WG may be disposed on an upper surface of the functional layer FL. The cover glass WG may be the outermost layer of the window WM. The cover glass WG may be disposed on the uppermost layer of the window WM, and an upper surface of the cover glass WG may define the uppermost surface of the window WM.

The cover glass WG may include glass. The cover glass WG may be a tempered glass substrate. FIG. 5A illustrates an embodiment where the upper surface of the cover glass WG is flat. In another embodiment, the cover glass WG may include a curved surface portion having curved edges. In an embodiment, for example, the cover glass WG may include a curved surface portion which overlaps the printed layer BM on an upper surface spaced apart from the functional layer FL. In an embodiment, a lower surface of the cover glass WG may have a planar shape. In an embodiment, the cover glass WG may not include a curved surface portion, and a shape of the cover glass WG is not limited to any one embodiment.

The window WM-1 shown in FIG. 5B is substantially the same as the window WM shown in FIG. 5A except that a decorative film DF is further included between the base layer BL and the functional layer FL. Referring to FIG. 5B, in an embodiment, the decorative film DF may be disposed on the base layer BL. In an embodiment, for example, the decorative film DF may be disposed on an upper surface of the base layer BL. In an embodiment, the decorative film DF may be an adhesive layer disposed between the base layer BL and the functional layer FL. The decorative film DF may include or be formed of a transparent adhesive, for example, an optically clear adhesive (OCA), etc.

FIGS. 5C to 5E are respectively enlarged cross-sectional views of region BB of the window WM illustrated in FIG. 5A. The description of the functional layer FL described with reference to FIGS. 5C to 5E may be similarly applied to the embodiment of a window WM-1 shown in FIG. 5B.

Referring to FIG. 5C, the functional layer FL may be disposed between the cover glass WG and the base layer BL. In an embodiment, for example, the functional layer FL may have a thickness t_{FL} in a range of about 295 nanometers (nm) to about 365 nm. However, an embodiment of the invention is not limited thereto. The thickness t_{FL} of the functional layer FL may be appropriately adjusted within a range in which a thickness of the display device DD (see FIG. 3) does not excessively increase and color and properties of the cover glass WG do not deteriorate.

The functional layer FL of an embodiment may include a first coating layer CL1 and a second coating layer CL2. The first coating layer CL1 and the second coating layer CL2 may be disposed on the base layer BL. In an embodiment, for example, the first coating layer CL1 may be disposed to be more adjacent to the base layer BL than the second coating layer CL2 is, and the second coating layer CL2 may be disposed to be spaced apart from the base layer BL. The first coating layer CL1 and the second coating layer CL2 may be formed through a deposition process using an evaporator.

The thickness t_{CL1} of the first coating layer CL1 may be less than the thickness t_{CL2} of the second coating layer CL2. The thickness t_{CL1} of the first coating layer CL1 may be in a range of about 9% to about 10% of a thickness t_{FL} of the functional layer FL. In an embodiment, for example, the first coating layer CL1 may have a thickness t_{CL1} in a range of about 26 nm to about 40 nm, but is not limited thereto.

The first coating layer CL1 may include or contain aluminium oxide (AlOₓ). The first coating layer CL1 may have a single-layered structure formed of or including a single material. In an embodiment, for example, the first coating layer CL1 may be a single layer formed of aluminium oxide (AlOₓ). The first coating layer CL1 may not include a plurality of layers. The first coating layer CL1 will be described later in greater detail.

The second coating layer CL2 may be disposed on the first coating layer CL1. The second coating layer CL2 may be directly disposed on an upper surface of the first coating layer CL1. The second coating layer CL2 may include a plurality of sub-layers. The plurality of sub-layers may have a low-refractive-index property, and/or a high-refractive-index property. The second coating layer CL2 may have a multi-layered structure in which layers are each formed of a single material, or a multi-layered structure in which layers are respectively formed of a plurality of materials.

The second coating layer CL2 may include an inorganic material. The second coating layer CL2 may include at least one selected from SiO or TiOₓ. In an embodiment, for example, the second coating layer CL2 may include at least one first sub-coating layer including SiO and at least one second sub-coating layer including TiOₓ. The first sub-coating layer may include SiO to exhibit the low-refractive-index property. The second sub-coating layer may include TiOₓ to exhibit the high-refractive-index property. Accordingly, the second coating layer CL2 may include at least one low-refractive-index layer and at least one high-refractive-index layer.

The window WM shown in FIG. 5D is substantially the same as the window WM shown in FIG. 5C except that the functional layer FL further includes a third coating layer CL3. Referring to FIG. 5D, in an embodiment, the functional layer FL may further include the third coating layer CL3 disposed on the second coating layer CL2.

The third coating layer CL3 may be disposed to provide improved impact resistance. The third coating layer CL3 is the uppermost part layer of the functional layer FL, and may protect, against external impacts, the first and second coating layers CL1 and CL2 disposed below the third coating layer CL3 as well as the display panel DP (see FIG. 3). Therefore, the window WM including the third coating layer CL3 may exhibit increased strength.

The third coating layer CL3 may include an organic material. The third coating layer CL3 of an embodiment includes silicon oxycarbide (SiOC), and may thus exhibit high impact resistance. The first coating layer CL1 may have a single-layered structure formed of a single material or a plurality of materials. In an embodiment, for example, the third coating layer CL3 may be a single layer including or formed of SiOC. However, this is illustrated as an example, and the third coating layer CL3 may further include a material for improving an impact resistance in addition to SiOC.

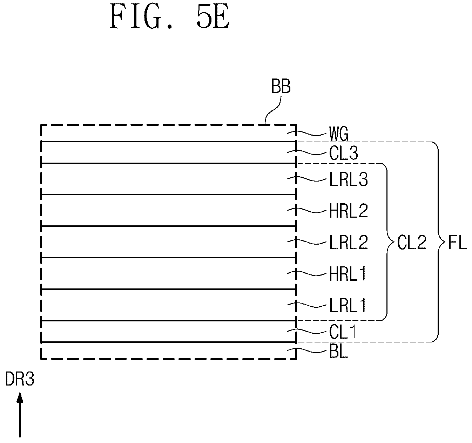

FIG. 5E is a cross-sectional view illustrating an embodiment where the second coating layer CL2 included in the window WM includes a plurality of low-refractive-index layers LRL1, LRL2, and LRL3, and a plurality of high-refractive-index layers HRL1 and HRL2.

Referring to FIG. 5E, in an embodiment, the second coating layer CL2 may include a first low-refractive-index layer LRL1, a second low-refractive-index layer LRL2, a third low-refractive-index layer LRL3, a first high-refractive-index layer HRL1, and a second high-refractive-index layer HRL2. In the second coating layer CL2, a layer having the low-refractive-index property, and a layer having the high-refractive-index property may be alternately stacked in the thickness direction DR3. In an embodiment, for example, the first low-refractive-index layer LRL1 may be disposed on the first coating layer CL1, the first high-refractive-index layer HRL1 may be disposed on the first low-refractive-index layer LRL1, the second low-refractive-index layer LRL2 may be disposed on the first high-refractive-index layer HRL1, the second high-refractive-index layer HRL2 may be disposed on the second low-refractive-index layer LRL2, and the third low-refractive-index layer LRL3 may be disposed on the second high-refractive-index layer HRL2. That is, in the second coating layer CL2, the first low-refractive-index layer LRL1, the first high-refractive-index layer HRL1, the second low-refractive-index layer LRL2, the second high-refractive-index layer HRL2, and the third low-refractive-index layer LRL3 may be sequentially stacked on the first coating layer CL1.

The first to third low-refractive-index layers LRL1, LRL2, and LRL3 may include a same material as each other. In an embodiment, for example, the first to third low-refractive-index layers LRL1, LRL2, and LRL3 may each include SiO. The first to third low-refractive-index layers LRL1, LRL2, and LRL3 are not limited thereto, and in another embodiment, the first to third low-refractive-index layers LRL1, LRL2, and LRL3 may include materials different from each other.

The first and second high-refractive-index layers HRL1 and HRL2 may include a same material as each other. In an embodiment, for example, the first and second high-refractive-index layers HRL1 and HRL2 may each include TiOₓ. The first and second high-refractive-index layers HRL1 and HRL2 are not limited thereto, and in another embodiment, the first and second high-refractive-index layers HRL1 and HRL2 may include materials different from each other.

Referring to FIGS. 5C to 5E, in an embodiment, the first coating layer CL1 may have a film density which is controlled to fall within a specific range. In an embodiment, the first coating layer CL1 may have a density of about 2.0 grams per cubic centimeter (g/cm³) or greater. In such an embodiment, if the first coating layer CL1 has a density of less than about 2.0 g/cm³, discoloration may occur in a border of the window WM. In such an embodiment, for example, if the window which includes the first coating layer having a density of less than about 2.0 g/cm³ is exposed to a high temperature condition of about 85 °C or higher, yellowing may occur at edges. The window WM of an embodiment includes the first coating layer CL1 having a density of about 2.0 g/cm³ or greater, and thus discoloration may not occur at the edges of the window WM under any circumstances. Therefore, the electronic devices ED and ED-a (see FIGS. 1A to 2) including the window WM of an embodiment may maintain high display quality.

Embodiments of the electronic device ED and ED-a may be used in various usage environments. For example, embodiments of the electronic device ED and ED-a may be exposed to the extremely high temperature condition of about 85 °C or higher. In this case, the density of the first coating layer CL1 of the window WM may decrease compared to that initially formed. In an embodiment, for example, under the extremely high temperature condition, the density of the first coating layer CL1 may decrease by an amount in a range of about 0.01 g/cm³ to about 0.3 g/cm³.

In consideration of the density decreasing under the extreme condition such as a high temperature, the first coating layer CL1 of an embodiment may have a density of about 2.3 g/cm³ or greater. The first coating layer CL1 has a density controlled to about 2.0 g/cm³ or greater, or to about 2.3 g/cm³ or greater, and thus the window WM including the first coating layer CL1 may exhibit high reliability without occurrence of discoloration at the edges.

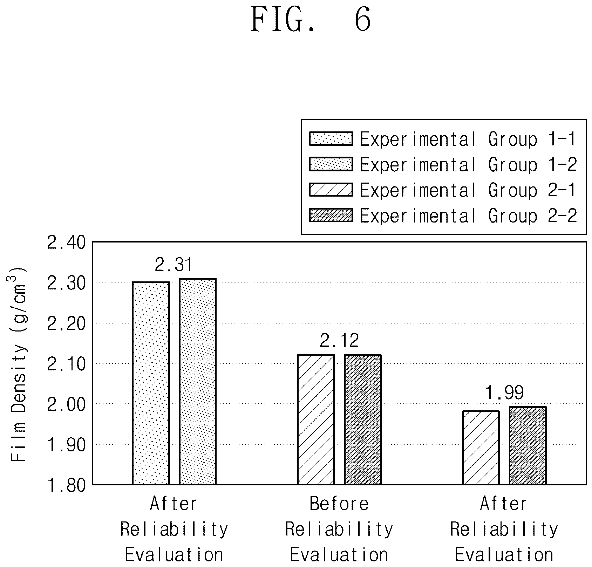

FIG. 6 is a graph showing reliability evaluation results of windows of experimental groups. Table 1 below shows whether yellowing occurred before and after reliability evaluations of the windows of an experimental group 1-1, an experimental group 1-2, an experimental group 2-1, and an experimental group 2-2. The windows of the experimental group 1-1, the windows of the experimental group 1-2, the windows of the experimental group 2-1, and the windows of the experimental group 2-2 all have the structure of FIG. 5A and include the structure of the functional layer FL illustrated in FIG. 5E.

In the windows of the experimental groups, the base layer was formed of a polyethylene terephthalate (PET) film, and the first coating layer was formed of AlOₓ. The first coating layers of the windows of the experimental group 1-1, the experimental group 1-2, the experimental group 2-1, and the experimental group 2-2 respectively have densities as shown in FIG. 6. Additionally, in the windows of the experimental groups, the first low-refractive-index layer, the second low-refractive-index layer, and the third low-refractive-index layer were formed of SiO, and the first high-refractive-index layer and the second high-refractive-index layer were formed of TiOx. The third coating layer was formed of SiOC, and the cover glass was formed from tempered glass.

Table 1 shows an average value of film densities which were measured before and after reliability evaluations of the windows of the experimental group 1-1, the experimental group 1-2, the experimental group 2-1, and the experimental group 2-2. In Table 2, "X" means that yellowing did not occur at the edges of the window, and "O" means that yellowing occurred at the edges of the window.

Additionally, in Table 1, the wording "before reliability evaluation" is intended to indicate a density of the first coating layer measured immediately after the manufacturing of the window through the above-described method, and the wording "after reliability evaluation" is intended to indicate a density of the first coating layer measured after immersing the window into water at about 90 °C and then performing accelerated evaluation using the above-described method.

**[Table 1]**

| | Before Reliability Evaluation (g/cm³) | After Reliability Evaluation (g/cm³) |
|---|---|---|
| Average value of Film Densities of Experimental Group 1-1 and Experimental Group 1-2 | - | 2.31 |
| Average value of Film Densities of Experimental Group 2-1 and Experimental Group 2-2 | 2.12 | 1.99 |

**[Table 2]**

| | Before Reliability Evaluation | After Reliability Evaluation |
|---|---|---|
| Experimental Group 1-1 | X | X |
| Experimental Group 1-2 | X | X |
| Experimental Group 2-1 | X | O |
| Experimental Group 2-2 | X | O |

Referring to FIG. 6, Table 1, and Table 2, it may be seen that the first coating layers of the experimental group 1-1 and the experimental group 1-2 had film densities of about 2.3 g/cm³ or greater even after the reliability evaluations, and no yellowing occurred at the edges.

Compared to this result, it was confirmed that in the experimental group 2-1 and experimental group 2-2, an average value of the film densities of the first coating layers was about 2.12 g/cm³ before the reliability evaluations, and no yellowing occurred at the edges of the window. However, it was confirmed that in the experimental group 2-1 and the experimental group 2-2, the densities of the first coating layers decreased to about 1.99 g/cm³ after the reliability evaluations, and yellowing occurred at the edges of the window.

As a result, it may be confirmed that the window WM, of the embodiment, including the first coating layer CL1 having a density of about 2.0 g/cm³ or greater, does not cause yellowing, and thus exhibits high reliability. Additionally, since the film density of the first coating layer may decrease under the condition such as a high temperature, the window WM of an embodiment may include the first coating layer CL1 having a density controlled to about 2.3 g/cm³ or greater to ensure higher reliability.

As described above, the window WM of an embodiment includes the first coating layer CL1 including or containing aluminium oxide (AlOₓ) and controlled to have a specific density, and thus no yellowing may occur at the edges not only in normal environments but also in extreme usage environments. Accordingly, the electronic devices ED and ED-a of an embodiment including the window WM of an embodiment maintain high reliability even under the extremely high temperature condition, and may thus exhibit high durability and stable display quality.

In a case where a fluorine (F) element is introduced during the thin film deposition using AlOₓ, the AlOₓ and the fluorine (F) may be reacted to form AlF₃. When AlF₃ is included in a thin film, the amount of moisture adsorbed by the thin film may increase. Therefore, the porosity of the thin film increases, which may result in deterioration of the thin film property. Accordingly, the first coating layer CL1 of an embodiment may not include a fluorine (F) element. The first coating layer CL1 including or containing AlOₓ does not include the fluorine (F) element, and thus deterioration of the thin film property may be prevented.

In some embodiments, the first coating layer CL1 may include at least a portion of a fluorine (F) element during the AlOₓ deposition process due to a contaminated deposition chamber. When the first coating layer CL1 includes a fluorine (F) element, the fluorine element in the first coating layer CL1 may be included in a concentration range in which a thin film property of the first coating layer CL1 does not deteriorate.

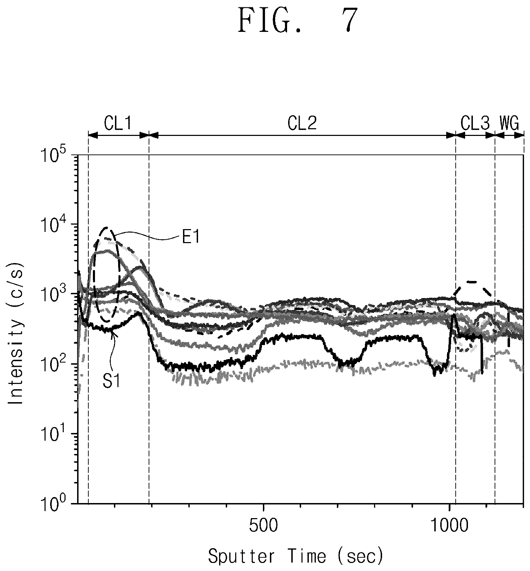

FIG. 7 is a graph showing a result of analyzing the concentration of fluorine (F) included in a window. FIG. 7 shows a result of a depth profile of the F element obtained by analyzing windows of the experimental groups through x-ray photoelectron spectroscopy (XPS). In FIG. 7, an x-axis presents a sputter time, and a stacked structure of the window along the thickness direction may be confirmed from the sputter time. In FIG. 7, the stacked structure of the window is represented by dividing into CL1, CL2, CL3, and WG according to the sputter times. In FIG. 7, CL1 is referred to as a first coating layer, and CL2 is referred to as a second coating layer. Additionally, in FIG. 7, CL3 is referred to as a third coating layer, and WG is referred to as a cover glass. A y-axis presents a peak intensity of a fluorine element based on a log value.

The above-described reliability experiments were performed on the windows of experimental groups S1 and E1 of FIG. 7, and then whether discoloration occurred was measured. In FIG. 7, it was confirmed that the experimental group S1 was a desired or normal product in which no yellowing occurred at a border of the window. In FIG. 7, it was confirmed that all the experimental groups E1 were defective products in which yellowing occurred in a border of the window.

Referring to FIG. 7, in the first coating layer of the experimental group S1 in which no yellowing occurred at the border of the window, the peak intensity of a fluorine element was about 5 × 10² counts per second (c/s) or less (based on a log value). Accordingly, it may be seen that in a case where the fluorine element is included in the first coating layer CL1, no yellowing occurred in the window when the first coating layer CL1 of one embodiment has a peak intensity controlled to about 5 × 10² c/s or less. On the other hand, when the peak intensity of the fluorine element included in the first coating layer exceeds about 5 × 10² c/s, as in the case of the experimental groups E1, yellowing may occur at the edges of the window. The window WM of an embodiment includes the first coating layer CL1 in which a peak intensity of the fluorine element is about 5 × 10² c/s or less, and thus occurrence of yellowing at the border may be effectively prevented.

The window WM of an embodiment may have a color difference (ΔE) of less than about 14. Specifically, the window WM of an embodiment, which includes the first coating layer CL1 having a density and a concentration of fluorine element controlled to fall within the above-mentioned range, may have a color difference (ΔE) of about 1 or less. Therefore, the window WM of an embodiment may provide high reliability without color change.

Table 3 below shows results of measuring the color differences ΔE of the windows of Example 1 and Comparative Examples. All the windows of Example 1 and the Comparative Examples have the structure of FIG. 5A and include the structure of the functional layer FL illustrated in FIG. 5E. In Example 1 and the Comparative Examples, first coating layers formed of AlOₓ have film densities of about 2.31 g/cm³ and the first coating layers have different fluorine concentrations. In Example 1, the peak intensity of a fluorine element confirmed through x-ray photoelectron spectroscopy (XPS) is about 5 × 10² c/s or less, and in the Comparative Examples, the peak intensities of fluorine elements exceed about 5 × 10² c/s. Table 3 shows results of the color differences (ΔE) as measured by a spectroscope.

**[Table 3]**

| | Color Difference(ΔE) |
|---|---|
| Example 1 | <1 |
| Comparative Example 1 | 21.8 |
| Comparative Example 2 | 20.7 |
| Comparative Example 3 | 20.3 |
| Comparative Example 4 | 19.8 |
| Comparative Example 5 | 19.2 |
| Comparative Example 6 | 18.8 |
| Comparative Example 7 | 18 |
| Comparative Example 8 | 17.9 |
| Comparative Example 9 | 17.5 |
| Comparative Example 10 | 17.3 |
| Comparative Example 11 | 16.8 |
| Comparative Example 12 | 16 |

Referring to Table 3, it may be seen that Example 1 had a significantly less changes in color than the Comparative Examples. Specifically, it may be seen that since the window of Example 1 includes the first coating layer formed of AlOₓ, the first coating layer has a density controlled to about 2.0 g/cm³ or greater, a fluorine has a concentration controlled to have a peak intensity of about 5 x 10² c/s or less, and thus the color difference (ΔE) is less than about 1.

On the other hand, it may be confirmed that in the Comparative Examples, a concentration of the fluorine of the first coating layer included in the window was high, and thus the color difference (ΔE) was about 16 or greater, resulting in a much greater change in color.

A window according to an embodiment includes a coating layer including or containing aluminium oxide and having a predetermined film density, and thus discoloration at edges does not occur even in various usage environments. Therefore, color change is substantially reduced or effectively prevented and the window may exhibit high reliability.

An electronic device according to an embodiment may include the above-mentioned window to exhibit high durability even when exposed to various extreme environments, thereby providing stable display quality.

The invention should not be construed as being limited to the embodiments set forth herein. Rather, these embodiments are provided so that this disclosure will be thorough and complete and will fully convey the concept of the invention to those skilled in the art.

While the invention has been particularly shown and described with reference to embodiments thereof, it will be understood by those of ordinary skill in the art that various changes in form and details may be made therein without departing from the scope of the invention as defined by the following claims.

## Claims

1. A window comprising:
a base layer;
a functional layer disposed on the base layer; and
a cover glass disposed on the functional layer,
wherein the functional layer includes:
a first coating layer disposed on the base layer, including aluminium oxide (AlOₓ), and having a density of about 2.0 g/cm³ or greater; and
a second coating layer disposed on the first coating layer and including an inorganic material.

2. The window of claim 1, wherein the first coating layer has a density of about 2.3 g/cm³ or greater.

3. The window of claim 1 or claim 2, wherein:
(i) the first coating layer does not include a fluorine element; or
(ii) the first coating layer further includes a fluorine element, and
when analyzed through X-ray photoelectron spectroscopy (XPS), the fluorine element included in the first coating layer has a peak intensity of about 5 × 10² c/s or less.

4. The window of any one of claims 1 to 3, wherein the functional layer has a thickness in a range of about 295 nm to about 365 nm.

5. The window of any one of claims 1 to 4, wherein a thickness of the first coating layer is less than a thickness of the second coating layer.

6. The window of any one of claims 1 to 5, wherein the first coating layer has a thickness in a range of about 26 nm to about 40 nm.

7. The window of any one of claims 1 to 6, wherein the second coating layer comprises a low-refractive-index layer, and a high-refractive-index layer.

8. The window of claim 7, wherein the second coating layer comprises:
a first low-refractive-index layer disposed on the first coating layer,
a first high-refractive-index layer disposed on the first low-refractive-index layer,
a second low-refractive-index layer disposed on the first high-refractive-index layer,
a second high-refractive-index layer disposed on the second low-refractive-index layer, and
a third low-refractive-index layer disposed on the second high-refractive-index layer.

9. The window of claim 8, wherein the first low-refractive-index layer, the second low-refractive-index layer, and the third low-refractive-index layer include a same material as each other, and
the first high-refractive-index layer, and the second high-refractive-index layer include a same material as each other.

10. The window of any one of claims 1 to 9, wherein the second coating layer includes at least one selected from SiO or TiOₓ, optionally wherein the second coating layer comprises:
a first sub-coating layer including the SiO, and
a second sub-coating layer including the TiOₓ.

11. The window of any one of claims 1 to 10, wherein the functional layer further comprises a third coating layer disposed on the second coating layer and including an organic material, optionally wherein the third coating layer includes SiOC.

12. A window comprising:
a base layer;
a first coating layer disposed on the base layer, including aluminium oxide (AlOₓ), and having a density of about 2.3 g/cm³ or greater;
a first low-refractive-index layer disposed on the first coating layer;
a first high-refractive-index layer disposed on the first low-refractive-index layer;
a second low-refractive-index layer disposed on the first high-refractive-index layer;
a second high-refractive-index layer disposed on the second low-refractive-index layer; and
a third low-refractive-index layer disposed on the second high-refractive-index layer.

13. The window of claim 12, wherein:
(i) each of the first low-refractive-index layer, the second low-refractive-index layer, and the third low-refractive-index layer includes SiO, and
each of the first high-refractive-index layer and the second high-refractive-index layer includes TiOₓ; and/or
(ii) the first coating layer further includes a fluorine element, and
when analyzed through X-ray photoelectron spectroscopy (XPS), the fluorine element included in the first coating layer has a peak intensity of about 5 × 10² c/s or less.

14. An electronic device comprising:
a first display device which includes a folding region foldable with respect to a folding axis extending in one direction, and a first non-folding region and a second non-folding region spaced apart with the folding region therebetween, wherein the first display device displays a first image in the folding region, the first non-folding region, and the second non-folding region; and
a second display device disposed to overlap the first non-folding region, wherein the second display device displays a second image in a direction opposite to the first image,
wherein the second display device includes a display panel, and a window disposed on the display panel,
the window includes a base layer, and a functional layer disposed on the base layer, and
the functional layer includes:
a first coating layer disposed on the base layer, including aluminium oxide (AlOₓ), and having a density of about 2.0 g/cm³ or greater; and
a second coating layer disposed on the first coating layer and including an inorganic material.

15. The electronic device of claim 14, wherein:
(i) the second display device does not overlap the folding region and the second non-folding region; and/or
(ii) the first coating layer has a density of about 2.3 g/cm³ or greater.
